# FASCICULE DE BREVET EUROPEEN

(11) **EP 2 800 461 B1**
(45) Date de publication et mention de la délivrance du brevet: **02.05.2018**
(21) Numéro de dépôt: 14167025.7
(22) Date de dépôt: 05.05.2014
(51) Int. Cl.: H05K 1/03, G06K 19/077, H05K 1/18, H05K 3/20

(54) **Procédé de fabrication d'un circuit flexible pour module de carte à puce, circuit flexible de carte à puce obtenu par ce procédé et module de carte à puce comportant un tel circuit flexible**
Herstellungsverfahren eines flexiblen Schaltkreises für Chipkartenmodul, mit diesem Verfahren hergestellter flexibler Schaltkreis für Chipkartenmodul und Chipkartenmodul, das einen solchen flexiblen Schaltkreis umfasst
Method for manufacturing a flexible circuit for a chip-card module, flexible chip-card circuit obtained by said method and chip-card module comprising such a flexible circuit

(30) Priorité: 03.05.2013 FR 1354115
(43) Date de publication de la demande: 05.11.2014
(73) Titulaire: Linxens Holding, 78280 Guyancourt (FR)
(72) Inventeur: Laurens de Lopez, Claire, 78480 Verneuil sur Seine (FR); Imbiscuso, Bruno, 78200 Mantes la Jolie (FR); Mathieu, Christophe, 78200 Mantes la Jolie (FR)
(74) Mandataire: GIE Innovation Competence Group

(56) Documents cités:
- EP-A2- 1 926 357
- WO-A1-2010/086511
- WO-A2-2007/116056
- DE-A1-102006 060 801
- FR-A1- 2 967 363
- US-A- 4 784 893
- ADAM C SIEGEL ET AL: "Foldable Printed Circuit Boards on Paper Substrates", ADVANCED FUNCTIONAL MATERIALS, WILEY - V C H VERLAG GMBH & CO. KGAA, DE, vol. 20, no. 1, 8 janvier 2010 (2010-01-08), pages 28-35, XP001551577, ISSN: 1616-301X, DOI: 10.1002/ADFM.200901363 [extrait le 2009-10-15]

## Description

L'invention concerne le domaine des circuits flexibles (par exemple des connecteurs) pour module de carte à puce.

Les cartes à puce sont bien connues du public, qui en a de multiples usages : cartes de crédit, cartes SIM pour téléphones portables, cartes de transport, cartes d'identité, etc.

Les cartes à puce sont généralement constituées d'un support rigide, par exemple en matière plastique, constituant l'essentiel de la carte, dans lequel est incorporé un module électronique fabriqué séparément. Ce module électronique comporte un circuit imprimé généralement flexible muni d'une puce (circuit intégré) et de moyens de transmission pour transmettre des données de la puce à un dispositif lecteur de carte (lecture) ou de ce dispositif à la carte (écriture). Ces moyens de transmission des données peuvent être constitués d'une antenne et/ou d'un connecteur. Lorsque les moyens de transmission comprennent uniquement un connecteur, la carte à puce est dite « à contact ». Le connecteur comporte alors des contacts électriquement connectés à la puce et constitués de pistes métalliques conductrices affleurant sur le module électronique, en surface du support, pour une connexion par contact électrique avec un dispositif lecteur de carte. Il existe aussi des moyens de transmission comprenant uniquement une antenne, la carte à puce est alors dite « sans contact ». Dans ce cas, l'antenne est électriquement connectée à la puce et communique directement, ou par l'intermédiaire d'une autre antenne, dite antenne « booster », avec un dispositif lecteur de carte. Il existe enfin des cartes à puce dites « dual », dont les moyens de transmission comprennent à la fois un connecteur et une antenne. Dans la suite de ce document, nous nous intéressons plus particulièrement aux circuits flexibles sur lesquels sont réalisés les contacts et/ou l'antenne et/ou les antennes des modules de cartes « à contact », « sans contact » ou « dual ».

Dans l'art antérieur, les modules sont généralement formés à partir d'un substrat diélectrique recouvert sur au moins l'une de ses faces d'une couche métallique conductrice. Dans cette couche conductrice sont formés des moyens de transmission que ce soient des contacts et/ou une antenne. Par exemple, le document DE 10 2006 060801 A1 décrit un procédé selon le préambule de la revendication 1, dans lequel des pistes conductrice sont formées par électrodéposition. Lorsque les moyens de transmission correspondent à une antenne, les spires de l'antenne sont isolées électriquement et légèrement espacées les unes des autres, pour créer une inductance permettant d'accorder la transmission sans contact. Les substrats diélectriques utilisés dans l'art antérieur sont généralement en verre-epoxy FR4 ou G10, ou en PET (Polyethylene Terephthalate), en PEN (Polyethylene Naphthalate), en polyimide, etc. Ce substrat est généralement mince et flexible. L'ensemble constitué du substrat et des moyens de transmission forme un circuit flexible.

Un but de l'invention est de fournir une alternative aux circuits flexibles de l'art antérieur, qui satisfasse aux exigences et spécifications requises pour ce type d'application (par exemple, le produit fini doit être conforme à la norme ISO 10373).

A cet effet, il est prévu selon l'invention, un procédé de fabrication d'un circuit flexible pour module de carte à puce dans lequel au moins un contact électriquement conducteur est réalisé sur une face avant d'un substrat isolant comportant un feuillet de papier.

De manière surprenante, les inventeurs ont pu montrer que le papier pouvait être compatible avec les conditions habituelles de fabrication des circuits flexibles pour module de carte à puce. Notamment, un substrat comportant un feuillet de papier peut recevoir une couche de cuivre laminée sur celui-ci.

A cet effet, le contact électriquement conducteur peut être réalisé de plusieurs manières. Par exemple, il peut être réalisé par la technologie dite de « leadframe », c'est-à-dire selon laquelle une grille de connexion est découpée dans une feuille de matériau électriquement conducteur pour former plusieurs contacts électriques éventuellement reliés par des pistes conductrices. Le matériau électriquement conducteur est par exemple un métal tel que du cuivre ou un alliage de cuivre. Après découpe, puis éventuellement métallisation de la grille de connexion, celle-ci est déposée, adhérée et laminée sur le substrat. La métallisation consiste avantageusement en une étape de dépôt d'un métal précieux par galvanochimie.

En fait, cette façon de procéder est surtout avantageuse lorsque l'on souhaite métalliser la couche de matériau conducteur dans laquelle le contact électriquement conducteur est réalisé, sans fragiliser le papier en le plongeant dans une solution électrolytique. Ainsi, il est possible de réaliser la ou les étape(s) de métallisation avant que la feuille de matériau électriquement conducteur ne soit rendue solidaire du substrat, par exemple par lamination.

Alternativement, les contacts électriquement conducteurs sont réalisés par gravure d'une feuille de cuivre préalablement laminée sur le substrat. Dans ce cas, leur métallisation a lieu après lamination et avantageusement après gravure. Il peut être alors nécessaire que le papier soit suffisamment hydrophobe. Par exemple, le papier a une énergie de surface inférieure à 30mN/m et l'angle de contact avec l'eau est supérieur à 90°, afin que l'eau ne soit pas absorbée et afin d'éviter ou limiter une dégradation de la surface du papier par un contact de quelques minutes avec des bains très acides (pH<2) ou très basiques (pH>12). Un traitement pour rendre le papier plus hydrophobe consiste par exemple à l'imprégner de résines fluorées ou de latex (éventuellement synthétique). Des exemples de procédés utilisables pour rendre le papier hydrophobe sont décrits dans les demandes de brevet WO2012066015A1, EP1007202, dans les brevets US6342268 et US8637119.

Avantageusement, le papier est traité dans la masse plutôt qu'en surface uniquement.

Le papier est avantageusement stable dimensionnellement lorsqu'il subit des variations de température et/ou en humidité. Les bobines de papier sont avantageusement séchés avant les éventuelles étapes de lamination, gravure et métallisation, afin de limiter au maximum les retraits. Ainsi, un papier présentant un retrait inférieur à 0,35% au cours de ces étapes est préférable. Par exemple, on utilisera un papier présentant un retrait de 0,15%.

Dans ce texte, le papier est une matière fabriquée avec des fibres végétales réduites en pâte, étendue et séchée pour former une feuille mince. Il peut s'agir d'une pâte à base de cellulose.

Le substrat est avantageusement constitué à au moins 80% en poids de papier.

Le papier est d'origine naturelle et est recyclable. Il contribue ainsi à réaliser des substrats plus écologiques. De plus, le papier apporte de la souplesse (par rapport à un substrat rigide) aux modules de carte à puce.

Le substrat peut être partiellement ou complètement sous forme d'un feuillet de papier. Par exemple, le feuillet de papier peut être pris en sandwich entre la couche de matériau conducteur dans laquelle sont réalisés les contacts électriques et une autre couche ayant une autre fonction (protection, écrantage magnétique, etc.). Le substrat peut comporter une couche d'adhésif intercalée, ou d'autres couches d'autres matériaux, entre la couche de matériau conducteur et le reste du substrat sous-jacent.

Par convention, la face principale du substrat sur laquelle sont disposés les contacts est appelée face avant ou face contact. Le substrat a bien entendu une épaisseur délimitée par cette face avant et une autre face principale opposée à celle-ci et appelée face arrière ou face de la puce, par laquelle ou sur laquelle peut être montée une puce. Le circuit flexible ne comporte pas nécessairement une puce lors de sa première commercialisation, mais en vue d'une connexion électrique ultérieure de la puce aux contacts, il est prévu de réaliser au moins un puits de connexion au moins partiellement obturé par une zone arrière du contact.

Les puits de connexion sont réalisés lors d'une étape de perforation. Cette étape de perforation peut avoir lieu avant lamination sur le feuillet de papier ou le substrat comportant le feuillet de papier.

Selon la technologie de connexion par soudure de fils (« wire-bonding » selon la terminologie anglo-saxonne), la puce est montée dans l'épaisseur du substrat ou sur la face arrière du substrat. Elle est alors électriquement connectée aux contacts de la face avant par des fils conducteurs soudés sur ou dans les puits de connexion. De manière alternative, la puce munie de protubérances adaptées (« bumps » selon la terminologie anglo-saxonne) peut-être connectée aux contacts selon la technologie dite flip-chip, c'est-à-dire sur des plages métalliques situées sur la face arrière et reliées aux contacts de la face avant par des puits de connexion dont la paroi est métallisée.

L'invention concerne également un circuit flexible pour module de carte à puce obtenu par ce procédé, voire un module de carte à puce comprenant un tel circuit flexible.

D'autres caractéristiques et avantages de l'invention apparaîtront à la lecture de la description détaillée et des dessins annexés sur lesquels :
- La figure 1 représente schématiquement en perspective une carte à puce destinée à recevoir un connecteur selon l'invention ;
- Les figures 2a à 2j représentent schématiquement les différentes étapes d'un exemple de procédé conforme à l'invention ;
- la figure 3 représente schématiquement en coupe une portion de circuit flexible obtenu grâce au procédé des figures 2a à 2j ;
- la figure 4 représente schématiquement en coupe une portion d'une variante du circuit flexible obtenu grâce au procédé des figures 2a à 2j ;
- la figure 5 représente schématiquement en coupe une portion d'une autre variante du circuit flexible obtenu grâce au procédé des figures 2a à 2j ;
- les figures 6a à 6f représentent schématiquement les différentes étapes d'un autre exemple de procédé conforme à l'invention ; et
- la figure 7 représente schématiquement en perspective un exemple de module conforme à l'invention.

Plusieurs modes de réalisation et variantes de circuits flexibles selon l'invention sont décrits ci-dessous. Tous appartiennent au domaine de la carte à puce.

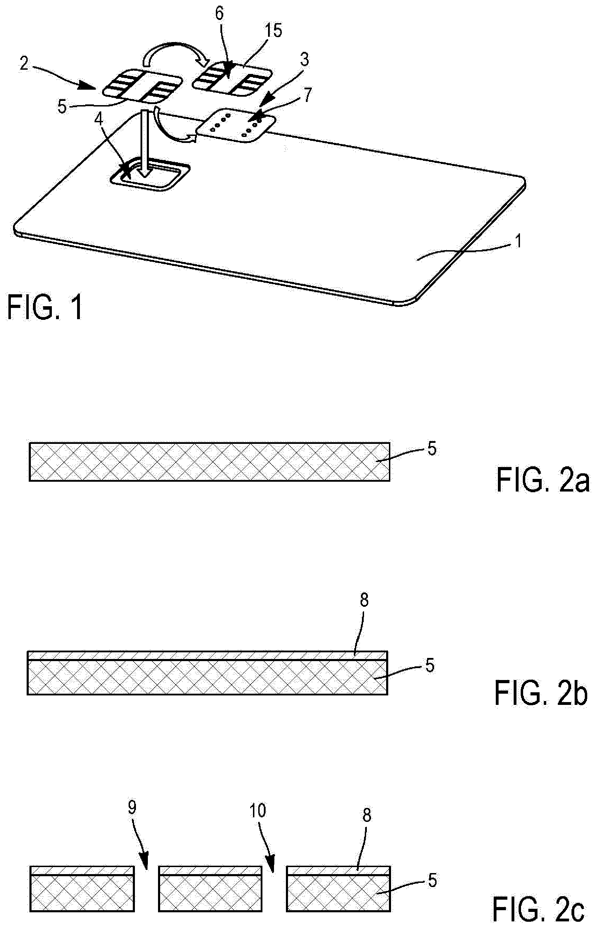

Comme représenté sur la figure 1, une carte à puce 1 comporte un module 2. Un module 2 comprend un circuit flexible 3 et une puce (non-représentée sur cette figure). Le module 2 est généralement réalisé sous forme d'un élément séparé qui est inséré dans une cavité 4 ménagée dans la carte 1.

Le circuit flexible 3 comporte un substrat 5 flexible, comprenant un feuillet de papier. Le circuit flexible 3 comporte également plusieurs contacts 15 auxquels sera ultérieurement connectée une puce.

Sur la figure 1, est représenté un exemple de circuit flexible 3. Ce circuit flexible 3 est représenté (en haut) vu par sa face avant 6 (face contact). Il est aussi représenté (en bas) vu par sa face arrière 7. Le circuit flexible 3 représenté correspond à un circuit flexible simple face. Mais il pourrait tout aussi bien s'agir d'un circuit flexible double face avec antenne (pour carte « dual ») ou d'un circuit flexible double face sans antenne ou encore d'un circuit flexible avec antenne mais sans contact.

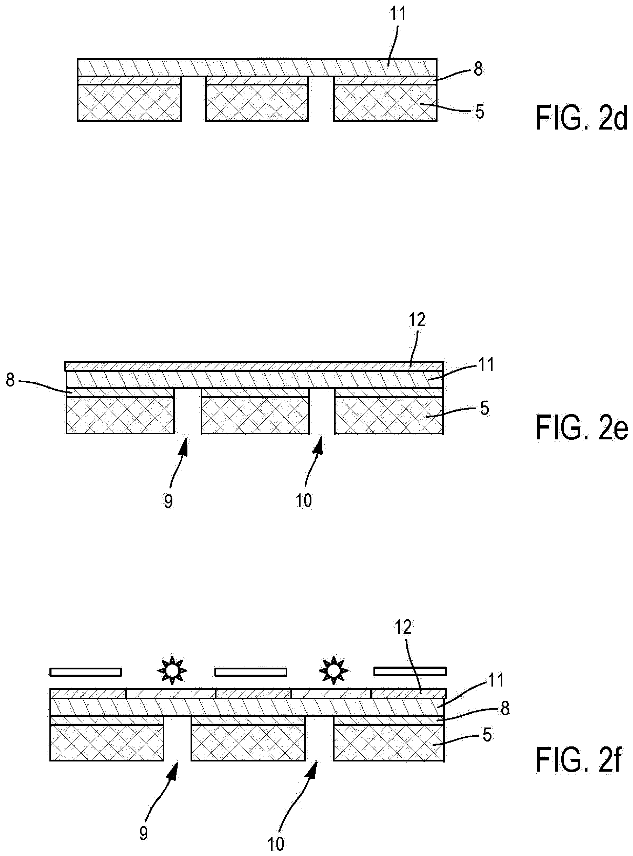

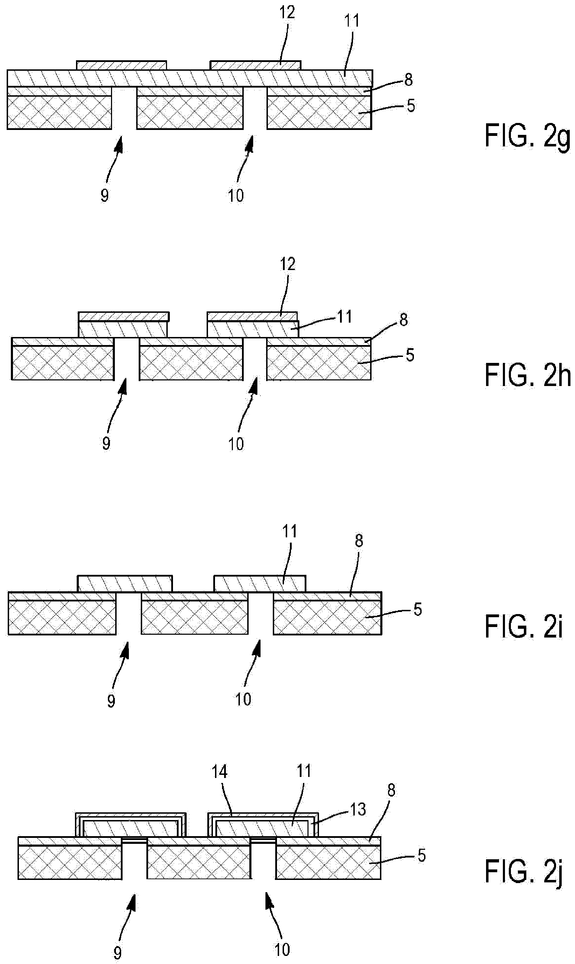

Les figures 2a à 2j illustrent schématiquement différentes étapes d'un exemple de procédé selon l'invention pour la fabrication du circuit flexible 3. Ces étapes comprennent :
- la fourniture (Fig. 2a) d'un substrat 5 comportant par exemple un feuillet de papier (en fait dans cet exemple, le substrat n'est initialement constitué que du feuillet de papier),
- l'enduction (Fig. 2b) du substrat 5 avec une couche d'adhésif 8 ;
- la perforation (Fig. 2c) de l'ensemble du substrat 5 et la couche d'adhésif, afin de réaliser des puits de connexion 9 et éventuellement une cavité 10 dans laquelle sera logée ultérieurement une puce ;
- le complexage (Fig. 2d) par lamination du substrat 5 muni de la couche d'adhésif 8 avec une couche conductrice 11 telle qu'une feuille de cuivre, puis réticulation à chaud de la couche d'adhésif 8 et désoxydation de la surface de la couche conductrice ;
- la lamination d'un film sec photosensible 12 sur la face du substrat 5 comportant la couche conductrice 11 (Fig. 2e) ;
- l'insolation du film photosensible 12 (Fig. 2f) ;
- le développement du film photosensible 12 (Fig. 2g) ;
- la gravure chimique de la couche conductrice 11 dans les zones non protégées par le film photosensible 12 (Fig. 2h) ;
- la dissolution (« strippage » selon la terminologie anglo-saxonne) du film photosensible 12 (Fig. 2i) ; et
- la métallisation des pistes et contacts obtenus après gravure de la couche conductrice 11 en une ou plusieurs étapes pour former une couche de nickel 13 et une couche d'or ou de palladium 14 (Fig. 2j).

Le papier utilisé pour le substrat est résistant aux étapes d'immersion dans les bains aqueux de pH extrêmes acides (pH<2) et basiques (pH>12) utilisés lors des étapes de gravure et de métallisation. Le papier utilisé est relativement hydrophobe. Par exemple, il est déperlant à l'eau. Par exemple, le papier a une énergie de surface inférieure à 30mN/m et l'angle de contact avec l'eau est supérieur à 90°.

L'utilisation d'un substrat 5 de papier est alors tout à fait compatible avec des étapes de dépôts galvano-chimiques de nickel, d'or, d'argent, de palladium ou d'alliages de ces derniers, et ceci quel que soit l'ordre de ces dépôts. En particulier, le papier ne perd pas ses propriétés mécaniques au cours des différentes étapes du procédé selon l'invention.

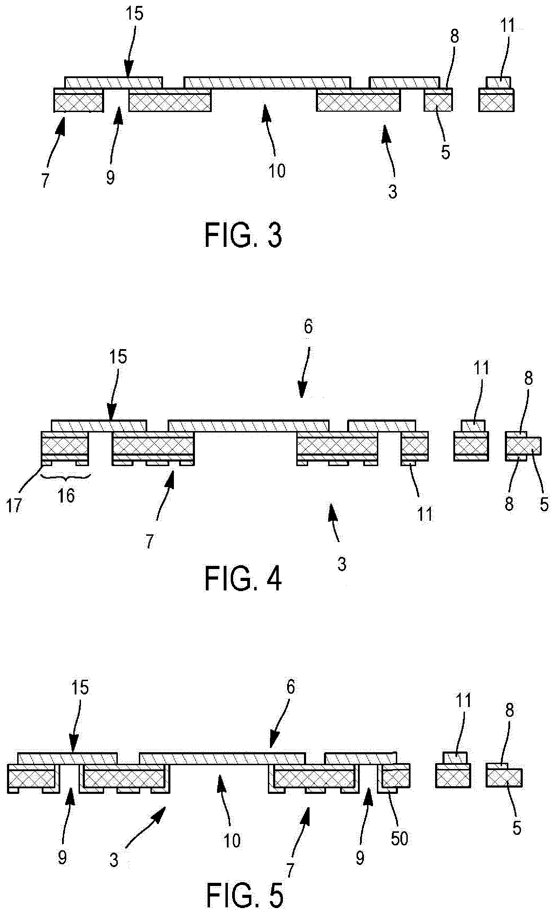

Le circuit flexible 3 obtenu par ce procédé est également représenté sur la figure 3 (pour simplifier la représentation, les couches de nickel, d'or et/ou de palladium sont représentées en tant que couches conductrices confondues avec celle de cuivre). Il comporte donc un substrat de papier 5, une couche d'adhésif 8 et une couche conductrice 11. L'étape de perforation mentionnée ci-dessus a permis de réaliser dans l'épaisseur du substrat 5 des puits de connexion 9 et une cavité pour la puce 10, obturés par une zone arrière des contacts 15.

Selon une variante représentée sur la figure 4, la face arrière 7 du substrat 5 comporte une antenne 16, avec des pistes 17, réalisée lors d'étapes analogues à celles décrites ci-dessus pour la réalisation des contacts 15.

Selon encore d'autres variante ou modes de réalisation (non représentés), une antenne peut être réalisée sur la face avant 6, autour ou à la place des contacts 15. La ou les pistes conductrices 17 de l'antenne est ou sont réalisée(s) lors d'étapes analogues à celles décrites ci-dessus pour la réalisation des contacts 15.

En fait, quelle que soit la fonction des pistes 17 ou contacts 15 réalisés sur la face avant 6 et/ou la face arrière 7, ceux-ci peuvent être obtenus par un procédé analogue à celui décrit ci-dessus.

Selon un autre mode de réalisation du circuit flexible selon l'invention, représenté sur la figure 5, les puits de connexion 9 sont métallisés, selon une technologie connue de l'homme de l'art, pour connecter électriquement la face avant 6 et la face arrière 7.

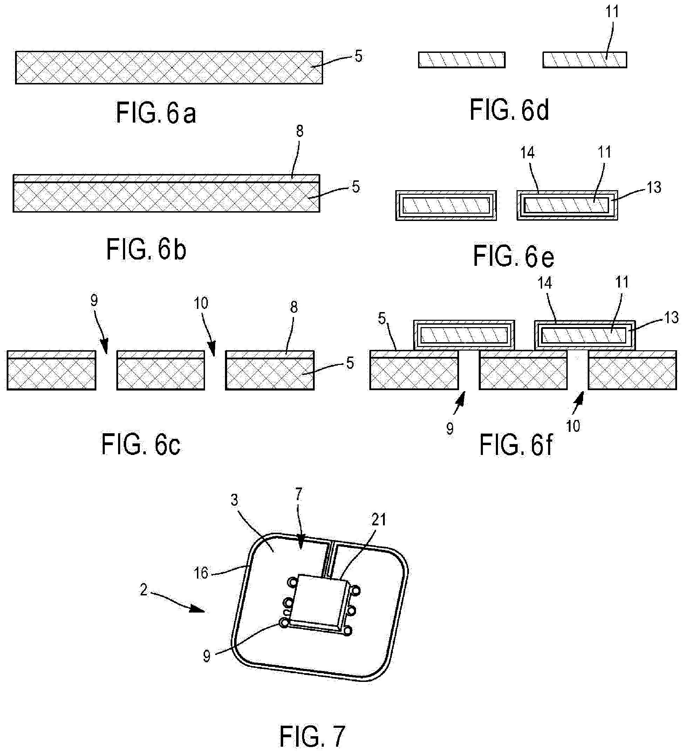

Un autre procédé de fabrication du circuit flexible selon l'invention est représenté sur les figures 6a à 6f. Les étapes de ce procédé comprennent :
- la fourniture (Fig. 6a) d'un substrat 5 comportant par exemple un feuillet de papier (en fait dans cet exemple encore, le substrat n'est initialement constitué que du feuillet de papier),
- l'enduction (Fig. 6b) du substrat 5 avec une couche d'adhésif 8 ;
- la perforation (Fig. 6c) de l'ensemble du substrat 5 et de la couche d'adhésif, afin de réaliser des puits de connexion 9 et éventuellement une cavité 10 dans laquelle sera logée ultérieurement une puce 21 (voir Fig. 7);
- la découpe séparée d'une couche conductrice 11 telle qu'une feuille de cuivre pour former des contacts 15 (Fig. 6d);
- la métallisation des pistes et contacts obtenus après découpe de la couche conductrice 11 en une ou plusieurs étapes pour former une couche de nickel 13 et une couche d'or ou de palladium 14 (Fig. 6e) ; et
- le complexage (Fig. 6f) par lamination du substrat 5 muni de la couche d'adhésif 8 avec la couche conductrice 11 telle qu'une feuille de cuivre, puis réticulation à chaud de la couche d'adhésif 8 et désoxydation de la surface de la couche conductrice.

La figure 7 représente schématiquement un module 2 pour carte à puce selon l'invention, obtenu selon l'un ou l'autre des deux procédés décrits ci-dessus. Il comporte un circuit flexible 3 sur la face arrière 7 duquel est montée une puce 21. Sur cet exemple, il s'agit d'une carte « dual » dont la face arrière 7 comporte également une antenne 16. Des puits de connexion 9 métallisés permettent de connecter les contacts 15 présents sur la face opposée à la puce 21.

## Revendications

1. Procédé de fabrication d'un circuit flexible (3) pour module (2) de carte à puce, comprenant :
- la fourniture d'un substrat (5) isolant,
- la réalisation d'au moins un contact (15) électriquement conducteur sur une face avant (6) du substrat (5),
dans lequel le substrat (5) comporte un feuillet de papier,
**caractérisé par le fait que** le contact (15) électriquement conducteur est réalisé dans une feuille (11) de matériau électriquement conducteur laminée sur le substrat (5), avec une couche d'adhésif intercalée entre la feuille (11) de matériau électriquement conducteur et le feuillet de papier.

2. Procédé selon la revendication 1, dans lequel le substrat (5) est perforé avant lamination de la feuille (11) de matériau électriquement conducteur sur celui-ci.

3. Procédé selon la revendication 1 ou 2, dans lequel le contact (15) électriquement conducteur est métallisé avant de laminer la feuille (11) de matériau électriquement conducteur sur le substrat (5).

4. Procédé selon l'une des revendications 1 à 3, dans lequel le contact (15) électriquement conducteur est découpé dans la feuille (11) de matériau électriquement conducteur avant de la laminer sur le substrat.

5. Procédé selon la revendication 1 ou 2, dans lequel le contact (15) électriquement conducteur est métallisé après avoir laminé la feuille (11) de matériau électriquement conducteur sur le substrat (5).

6. Procédé selon l'une des revendications précédentes dans lequel le papier a une énergie de surface inférieure à 30mN/m.

7. Procédé selon l'une des revendications précédentes dans lequel le papier a un angle de contact avec l'eau supérieur à 90°.

8. Procédé selon l'une des revendications précédentes, dans lequel le substrat (5) est constitué à au moins 80 % en poids de papier.

9. Circuit flexible pour module (2) de carte à puce, comportant au moins un contact (15) électriquement conducteur sur une face avant d'un substrat (5) électriquement isolant et comportant un feuillet de papier,
**caractérisé par le fait que**
le contact (15) électriquement conducteur est réalisé dans une feuille (11) de matériau électriquement conducteur laminée sur le substrat (5), avec une couche d'adhésif intercalée entre la feuille (11) de matériau électriquement conducteur et le feuillet de papier.

10. Circuit flexible selon la revendication 9, dans lequel le papier a une énergie de surface inférieure à 30mN/m.

11. Circuit flexible selon la revendication 9 ou 10, dans lequel le papier a un angle de contact avec l'eau supérieur à 90°.

12. Module de carte à puce, comportant un circuit flexible (3) avec au moins un contact (15) électriquement conducteur sur une face avant (6) d'un substrat (5) électriquement isolant et comportant un feuillet de papier,
**caractérisé par le fait que** le contact (15) électriquement conducteur est réalisé dans une feuille (11) de matériau électriquement conducteur laminée sur le substrat (5), avec une couche d'adhésif intercalée entre la feuille (11) de matériau électriquement conducteur et le feuillet de papier.

13. Module selon la revendication 12, dans lequel le papier a une énergie de surface inférieure à 30mN/m.

14. Module selon la revendication 12 ou 13, dans lequel le papier a angle de contact avec l'eau supérieur à 90°.

## Patentansprüche

1. Herstellungsverfahren eines flexiblen Schaltkreises (3) für ein Chipkartenmodul (2), umfassend:
- Bereitstellen eines isolierenden Substrats (5),
- Realisierung mindestens eines elektrisch leitenden Kontakts (15) auf einer Vorderseite (6) des Substrats (5),
wobei das Substrat (5) ein Papierblättchen umfasst,
**dadurch gekennzeichnet, dass** der elektrisch leitende Kontakt (15) in einem Blatt (11) aus elektrisch leitendem Material, das auf das Substrat (5) laminiert ist, mit einer zwischen dem Blatt (11) aus elektrisch leitendem Material und dem Papierblättchen liegenden Klebstoffschicht realisiert wird.

2. Verfahren nach Anspruch 1, bei dem das Substrat (5) vor dem Auflaminieren des Blattes (11) aus elektrisch leitendem Material perforiert wird.

3. Verfahren nach Anspruch 1 oder 2, bei dem der elektrisch leitende Kontakt (15) vor dem Laminieren des Blattes (11) aus elektrisch leitendem Material auf das Substrat (5) metallisiert wird.

4. Verfahren nach einem der Ansprüche 1 bis 3, bei dem der elektrisch leitende Kontakt (15) vor dem Auflaminieren auf das Substrat in dem Blatt (11) aus elektrisch Leitendem Material zugeschnitten wird.

5. Verfahren nach Anspruch 1 oder 2, bei dem der elektrisch leitende Kontakt (15) nach dem Laminieren des Blattes (11) aus elektrisch leitendem Material auf das Substrat (5) metallisiert wird.

6. Verfahren nach einem der vorhergehenden Ansprüche, bei dem das Papier eine Oberflächenenergie unter 30 mN/m aufweist.

7. Verfahren nach einem der vorhergehenden Ansprüche, bei dem das Papier einen Kontaktwinkel mit dem Wasser von über 90° einnimmt.

8. Verfahren nach einem der vorhergehenden Ansprüche, bei dem das Substrat (5) zu mindestens 80 % des Gewichts aus Papier besteht.

9. Flexible Leiterplatte für ein Chipkartenmodul, umfassend mindestens einen elektrisch leitenden Kontakt (15) auf einer Vorderseite eines elektrisch isolierenden Substrates (5), das ein Papierblättchen umfasst,
**dadurch gekennzeichnet, dass**
der elektrisch leitende Kontakt (15) in einem Blatt (11) aus elektrisch leitendem Material, das auf das Substrat (5) laminiert ist, mit einer zwischen dem Blatt (11) aus elektrisch leitendem Material und dem Papierblättchen liegenden Klebstoffschicht realisiert wird.

10. Flexible Leiterplatte nach Anspruch 9, bei der das Papier eine Oberflächenenergie unter 30 mN/m aufweist.

11. Flexible Leiterplatte nach Anspruch 9 oder 10, bei der das Papier einen Kontaktwinkel mit dem Wasser von über 90° einnimmt.

12. Chipkartenmodul, umfassend eine flexible Leiterplatte (3) mit mindestens einem elektrisch leitenden Kontakt (15) auf einer Vorderseite (6) eines elektrisch isolierenden Substrates (5), das ein Papierblättchen umfasst,
**dadurch gekennzeichnet, dass** der elektrisch leitende Kontakt (15) in einem Blatt (11) aus elektrisch leitendem Material, das auf das Substrat (5) laminiert ist, mit einer zwischen dem Blatt (11) aus elektrisch leitendem Material und dem Papierblättchen liegenden Klebstoffschicht realisiert wird.

13. Modul nach Anspruch 12, bei dem das Papier eine Oberflächenenergie unter 30 mN/m aufweist.

14. Modul nach Anspruch 12 oder 13, bei dem das Papier einen Kontaktwinkel mit dem Wasser von über 90° einnimmt.

## Claims

1. Process for manufacturing a flexible circuit (3) for a chip-card module (2), comprising:
- providing an insulating substrate (5), and
- producing at least one electrically conductive contact (15) on a front face (6) of the substrate (5),
wherein the substrate (5) includes a sheet of paper,
**characterized in that** the electrically conductive contact (15) is produced in a sheet (11) of electrically conductive material, which sheet is laminated to the substrate (5), with an adhesive layer intermediate between the sheet (11) of electrically conductive material and the sheet of paper.

2. Process according to Claim 1, wherein the substrate (5) is perforated before lamination of the sheet (11) of electrically conductive material thereto.

3. Process according to Claim 1 or 2, wherein the electrically conductive contact (15) is metallized before the sheet (11) of electrically conductive material is laminated to the substrate (5).

4. Process according to one of Claims 1 to 3, wherein the electrically conductive contact (15) is cut from the sheet (11) of electrically conductive material before it is laminated to the substrate.

5. Process according to Claim 1 or 2, wherein the electrically conductive contact (15) is metallized after the sheet (11) of electrically conductive material has been laminated to the substrate (5).

6. Process according to one of the preceding claims, wherein the paper has a surface energy lower than 30 mN/m.

7. Process according to one of the preceding claims, wherein the paper has a contact angle with water larger than 90°.

8. Process according to one of the preceding claims, wherein the substrate (5) consists of at least 80% by weight of paper.

9. Flexible circuit for a chip-card module (2), said circuit including at least one electrically conductive contact (15) on a front face of an electrically insulating substrate (5) including a sheet of paper,
**characterized in that**
the electrically conductive contact (15) is produced in a sheet (11) of electrically conductive material, which sheet is laminated to the substrate (5), with an adhesive layer intermediate between the sheet (11) of electrically conductive material and the sheet of paper.

10. Flexible circuit according to Claim 9, wherein the paper has a surface energy lower than 30 mN/m.

11. Flexible circuit according to Claim 9 or 10, wherein the paper has a contact angle with water larger than 90°.

12. Chip-card module, including a flexible circuit (3) with at least one electrically conductive contact (15) on a front face (6) of an electrically insulating substrate (5) including a sheet of paper,
**characterized in that** the electrically conductive contact (15) is produced in a sheet (11) of electrically conductive material, which sheet is laminated to the substrate (5), with an adhesive layer intermediate between the sheet (11) of electrically conductive material and the sheet of paper.

13. Module according to Claim 12, wherein the paper has a surface energy lower than 30 mN/m.

14. Module according to Claim 12 or 13, wherein the paper has a contact angle with water larger than 90°.
